# EUROPÄISCHE PATENTSCHRIFT

(11) **EP 2 101 351 B1**
(45) Veröffentlichungstag und Bekanntmachung des Hinweises auf die Patenterteilung: **17.08.2016**
(21) Anmeldenummer: 08004683.2
(22) Anmeldetag: 13.03.2008
(51) Int. Cl.: H01L 23/433, H01L 23/473, H01L 23/467, H01L 23/367

(54) **Kühlvorrichtung zur Kühlung eines Bauteils**
Cooling device for cooling a component
Dispositif de refroidissement destiné au refroidissement d'un composant

(43) Veröffentlichungstag der Anmeldung: 16.09.2009
(73) Patentinhaber: Siemens Aktiengesellschaft, 80333 München (DE)
(72) Erfinder: Busch, Klaus, 92224 Amberg (DE); Scharf, Christian, 92263 Ebermannsdorf (DE); Wiesner, Christoph, 92224 Amberg (DE)

(56) Entgegenhaltungen:
- EP-A- 1 353 376
- GB-A- 2 358 464
- US-A- 5 077 601
- US-A- 5 361 188
- US-A- 6 125 921
- US-B1- 6 364 009
- US-B2- 7 010 930

## Beschreibung

Die Erfindung betrifft einen Kühlkörper zur Kühlung eines Bauteils, wobei der Kühlkörper von einem Medium umströmbar ist. Zudem betrifft die Erfindung eine Kühlvorrichtung zur Kühlung eines Bauteils. Des Weiteren betrifft die Erfindung eine elektronische Baugruppe mit einem Gehäuse und einer Kühlvorrichtung.

Ein wesentlicher Faktor beim Einsatz von elektronischen Geräten, z.B. CPU-Baugruppen von Automatisierungssystemen, ist das benötigte Bauvolumen und die daraus resultierenden Geräteabmessungen. Bei kleineren Gerätabmessungen muss eine größere Aufmerksamkeit auf eine Entwärmung der in dem Gerät angeordneten elektrischen Bauteile gerichtet werden. Ferner werden kürzere Verarbeitungszeiten der CPU-Baugruppen in Automatisierungssystemen gefordert, dies wiederum hat eine Erhöhung einer Taktfrequenz von eingesetzten Mikroprozessoren und somit wiederum einen Anstieg der Verlustleistung des Mikroprozessors, insbesondere bei den CPU-Baugruppen, zur Folge. Um bei kleineren Abmessungen der Baugruppe und erhöhter Prozessorleistung die Abwärme der Bauteile insbesondere die Abwärme der Mikroprozessoren abzuführen ist eine Kühlvorrichtung notwendig.

Aus dem Stand der Technik sind folgende Kühlvorrichtungen bekannt. In EP 1 529 963 A1 wird ein Aufbau einer Kühlvorrichtung mit einem Jet-Cooler vorgeschlagen. Der Jet-Cooler bläst Luft zwischen senkrecht stehende, rechteckförmige Kühlrippen eines Kühlkörpers. Auch in EP 1 715 566 A2 wird ein Aufbau mit einem Jet-Cooler und einem Kühlkörper vorgeschlagen. Auch hier wird über den Jet-Cooler Luft von der Seite zwischen die Kühlkörper geblasen. Weiterhin ist aus EP 1 717 936 A2 ein Notebook mit einer Kühlvorrichtung, bei dem ein Jet-Cooler seitlich Luft zwischen die Kühlrippen eines Kühlkörpers bläst, bekannt.

In der US 6 364 009 B1 wird eine Kühlvorrichtung offenbart, welche einen Kanal mit einem abnehmenden Querschnitt zwischen einem Einlass und einem Auslass aufweist.

Nachteilig an dem Stand der Technik ist, dass die bekannten Anordnungen einen erhöhten Platzbedarf fordern und zukünftigen Kühlaufgaben nicht mehr Rechnung tragen können.

Es ist daher die Aufgabe der Erfindung einen Kühlkörper bzw. eine Kühlvorrichtung mit einer effizienteren Entwärmung von elektrischen Bauteilen gegenüber den bekannten Kühlkörpern bzw. Kühlvorrichtungen bereitzustellen.

Die Aufgabe wird erfindungsgemäß bei dem eingangs genannten Kühlkörper dadurch gelöst, dass zur Kühlung eines Bauteils eine zumindest abschnittsweise Führung eines Hauptstromes und eines Nebenstromes des Mediums vorhanden ist, wobei der Hauptstrom von dem Nebenstrom bis zu einer Engstelle durch ein Trennmittel getrennt ist und sich nach der Engstelle der Nebenstrom mit dem Hauptstrom vermischt. Gemäß dem Kontinuitätsgesetz wird sich in einem für den Hauptstrom verengenden Strömungskanal, eine Strömungsgeschwindigkeit und damit ein Staudruck des Hauptstromes an der Engstelle erhöhen. Als Engstelle wird die Stelle bezeichnet, welche innerhalb des Strömungskanals den kleinsten Querschnitt aufweist. Aufgrund des durch die Engstelle hervorgerufenen erhöhten Volumenstromes steigt eine Wärmeaufnahmefähigkeit des Hauptstromes und es kommt auf vorteilhafte Weise zu einem größeren Kühleffekt.

Mit Vorteil ist das Trennmittel mit einer Unterseite in einer Schräglage zu einer dem Bauteil zugewandten Fläche des Kühlkörpers angeordnet. Mit weiterem Vorteil ist dabei das Trennmittel innerhalb des Kühlkörpers angeordnet. Der Kühlkörper innerhalb einer Baugruppe wird dadurch weniger Platz einnehmen, welches zu geringeren Abmessungen der Baugruppe führt.

Durch die Anordnung des Trennmittels in einer Schräglage zumindest teilweise innerhalb des Kühlkörpers kann an einer Oberseite des Trennmittels der Nebenstrom erzeugt werden und an einer Unterseite des Trennmittels der Hauptstrom vorbeigeführt werden. In einer sehr leicht zu realisierenden Ausführungsform ist das Trennmittel als ein Luftleitblech ausgestaltet. Der Begriff Luftleitblech bedeutet nicht unbedingt, dass das Trennmittel aus Metall ist. Es handelt sich hier lediglich um eine Art Leitlamelle aus einem beliebigen Werkstoff für eine Strömung, welche in den Kühlkörper eintritt. Das strömende Medium kann beispielsweise Luft oder ein anderes Gas oder flüssiges Kühlmittel sein.

Vorzugsweise sind die Unterseite und die Fläche als Begrenzungen eines Hauptstromkanals für den Hauptstrom angeordnet.

In weiterer vorteilhafter Ausgestaltung nimmt von einem Hauptlufteintritt ein für den Hauptstrom zur Verfügung stehender Querschnitt bis zur Engstelle ab. Ein derartig kontinuierlich sich verengender Strömungskanal begünstigt die Strömung und das spätere Ansaugen des Nebenstromes nach der Engstelle.

Bei einer Ausgestaltung des Kühlkörpers mit Kühlrippen sind vorzugsweise mehrere Kühlrippen senkrecht zur Fläche angeordnet.

Eine weitere Optimierung der Kühlleistung kann dadurch erreicht werden, dass die Kühlrippen derart ausgestaltet sind, dass der Nebenstrom aus einer kühlrippenfreien Zone angesaugt wird. Im Bereich des Nebenstromes sind beispielweise ausgehend von einem Lufteintritt über ein Lüftungsgitter einer Baugruppe bis zur Engstelle keine Kühlrippen ausgeprägt. Von daher erfährt der Nebenstrom bei Eintritt in die Baugruppe nur eine geringe Temperaturerhöhung, da er vor der Engstelle noch nicht in den Kontakt mit den Kühlrippen tritt, somit kann er seine kühlende Wirkung bei Eintritt in die Kühlrippen nach oder bei der Engstelle voll entfalten.

Die Strömungsbedingungen für den Hauptstrom und den Nebenstrom werden weiter optimiert, wenn das Trennmittel im Wesentlichen senkrecht zu den Kühlrippen und dabei in einem Winkel im Bereich von 45 bis 5 Grad, vorzugsweise im Bereich von 30 bis 10 Grad, vorzugsweise im Bereich von 25 bis 15 Grad zur Fläche angeordnet ist.

Die eingangs genannte Aufgabe wird durch die eingangs genannte Kühlvorrichtung mit einem Kühlkörper nach Anspruch 1 dadurch gelöst, dass das Trennmittel zumindest teilweise durch eine Unterseite eines Kühlmittelstrahlerzeugungsmittels ausgestaltet ist. Vorzugsweise ist das Kühlmittelstrahlerzeugungsmittels dabei schräg in einem Winkel im Bereich von 45 bis 5 Grad, vorzugsweise im Bereich von 30 bis 10 Grad, vorzugsweise im Bereich von 25 bis 15 Grad zu einer dem Bauteil zugewandten Fläche des Kühlkörpers angeordnet. Dabei ist das Trennmittel im Wesentlichen senkrecht zu den Kühlrippen angeordnet.

Zur weiteren Heraufsetzung der Kühlleistung ist vorzugsweise an der Fläche eine Grundplatte angeordnet. Durch diese Grundplatte kann ein Wärmetransport in der Grundplatte von dem zu kühlenden Bauteil in Richtung des Hauptstromes geführt werden, wobei die Grundplatte in Kontakt mit dem Bauteil steht.

Bei einer Kühlvorrichtung, wobei der Kühlkörper Kühlrippen aufweist, wobei die Kühlrippen derart ausgestaltet sind, dass innerhalb eines durch die maximalen dreidimensionalen Abmessungen des Kühlkörpers aufgespannten Raumes eine Ausnehmung zur Aufnahme des Kühlmittelstrahlerzeugungsmittels gebildet ist, wobei die Kühlrippen senkrecht zur Unterseite angeordnet sind, ist mit Vorteil das als Trennmittel verwendete Kühlmittelstrahlerzeugungsmittels zumindest teilweise innerhalb des Kühlkörpers angeordnet. Dadurch nimmt die Kühlvorrichtung innerhalb einer Baugruppe weniger Platz ein, welches zu geringeren Abmessungen einer Baugruppe führt.

Vorzugsweise ist das Kühlmittelstrahlerzeugungsmittel derart auf den Kühlrippen angeordnet, dass es über zumindest eine Öffnung das Medium zwischen die Kühlrippen appliziert. Dieses "einpumpen" von beispielweise gepulster Luft hinter, in Strömungsrichtung gesehen, der Engstelle verbessert die Kühlleistung um ein weiteres.

Bei einer elektronischen Baugruppe mit einem Gehäuse und einem Kühlkörper kann eine effiziente Entwärmung bei Einhaltung einer geforderten Minimal Baugröße gewährleistet werden.

Weitere für die Erfindung relevante Gedanken sind folgende: Gute Strömungsbedingungen für das Medium entstehen dann, wenn die Unterseite und die Fläche als Begrenzungen eines Hauptstromkanals für einen Hauptstrom angeordnet sind. Als Hauptstrom wird der Strom des Mediums bezeichnet, welcher nahe dem zu kühlenden Bauteil im Kühlkörper und über die Grundplatte des Kühlkörpers geführt wird.

Vorzugsweise ist das Kühlmittelstrahlerzeugungsmittel als ein Jet-Cooler ausgestaltet. Ein Jet-Cooler besitzt beispielsweise einen internen Aufbau umfassend ein Tauchspulenmagnetsystem, welches eine Membran in periodische Schwingungen versetzt. Diese Membran ist in einer Kammer integriert, die durch ein oder mehrere Öffnungen den periodischen Luftimpuls in Richtung des zu kühlenden Elementes z.B. eines Kühlkörpers gezielt ausrichtet. Im Einsatzgebiet der industriellen Automatisierungstechnik werden Jet-Cooler gegenüber Schaufelradlüftern aufgrund ihrer erhöhten Lebensdauer eingesetzt.

Eine zweckmäßige Ausgestaltungsform und weitere Erläuterungen ist der Zeichnung zu entnehmen. Es zeigen:
FIG 1 eine Baugruppe mit einem Gehäuse und einer Kühlvorrichtung und
FIG 2 einen Kühlkörper in einer dreidimensionalen Ansicht.

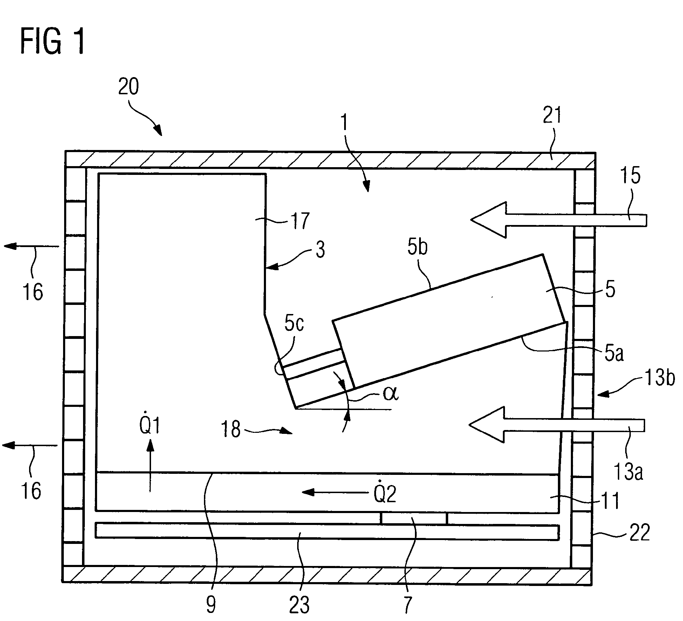

Gemäß FIG 1 ist eine Baugruppe 20 mit einer innerhalb eines Gehäuses 21 angeordneten Kühlvorrichtung 1 in einer Seitenansicht ohne Seitendeckel dargestellt. Die Kühlvorrichtung weist einen Kühlkörper 3 und einen Jet-Cooler 5 auf. Der Kühlkörper 3 ist auf einer Grundplatte 11 angeordnet. Diese Grundplatte 11 steht in thermischer Verbindung mit einem Bauteil 7. Das Bauteil 7 ist auf einer Leiterplatte 23 angeordnet. Mikroprozessoren von CPU-Baugruppen werden üblicher Weise mit derartigen Kühlvorrichtungen 1 gekühlt. Der Kühlkörper 3 ist im Wesentlichen als eine Quaderform mit einer Vielzahl von Kühlrippen 17 und einer Ausnehmung zur Aufnahme des Jet-Coolers 5 innerhalb des Raumes, welcher durch die maximalen dreidimensionalen Abmessungen des Kühlkörpers gebildet wird. Die Kühlrippen 17, welche in einem Abschnitt für einen Hauptstrom 13a unterhalb an der Unterseite 5a des Jet-Coolers 5 angeordnet sind, weisen einen Winkel α von 20 Grad zur Grundplatte 11 bzw. zur Fläche 9 des Kühlkörpers 3 auf. Unterhalb des Jet-Coolers kann über einen Hauptlufteintritt 13b der Hauptstrom 13a zwischen der Unterseite 5a des Jet-Coolers und einer Oberseite der Grundplatte 11 zwischen die Kühlrippen 17 einströmen. Der Hauptstrom 13a durchströmt dabei ein Lüftungsgitter 22, welches Bestandteil des Gehäuses 21 der Baugruppe 20 ist. Eine vorzugsweise Einbaurichtung dieser Baugruppe 20 ist, dass der Hauptstrom 13a von unten in die Baugruppe eintreten kann und als ein Abluftstrom 16 durch ein weiteres Lüftungsgitter oberhalb der Baugruppe 20 austreten kann. Für eine endgültige Einbaulage der Baugruppe 20 hätte die Baugruppe 20 also eine Einbauposition, welcher der gegenüber der Zeichnung einer um 90° rechts verdrehten Position entspricht.

An einer Engstelle 18 des Hauptstromes 13a kommt es infolge eines erhöhten Staudruckes der von außen angesaugten Luft zu einem sogenannten Wanddruckabfall nach dem Bernoulli-Gesetz. Dieser Wanddruckabfall an der Engstelle 18, die wie eine Düse wirkt, hat zur Folge, dass der Nebenluftstrom 15 aus einer kühlrippenfreien Zone angesaugt werden kann. Der gegenüber dem Hauptstrom 13a kühlere Nebenluftstrom kann sich nun an der Stelle links von der Engstelle 18 mit dem bereits aufgewärmten Hauptstrom 13a vereinigen und so für eine weitere Runterkühlung des Kühlkörpers 3 sorgen. Aufgrund dieser Temperaturabsenkung besteht zwischen dem Hauptstrom 13a nach der Engstelle 18 und der Oberseite der Grundplatte 11 ein Temperaturgefälle und es kann ein Wärmetransport *Q̇*1 zur durch die Kühlrippen 17 durchströmenden Luft erfolgen. Da nun ebenfalls in der Grundplatte 11 im Bereich einer Wärmequelle, welche durch das Bauteil 7 gegeben ist, und der Engstelle 18 sich ein weiteres Temperaturgefälle einstellt, findet auch ein weiterer Wärmetransport *Q̇*2 in dargestellter Pfeilrichtung innerhalb der Grundplatte 11 abführend von dem zu kühlenden Bauteil 7 statt. Vorteilhaft bei dieser Anordnung ist die Anordnung des Jet-Coolers 5 mit seiner Unterseite 5a zur Grundplatte 11 in einem Winkel von ca. 20°, dadurch wird die Engstelle 18 in Durchflussrichtung des Hauptstromes 13a zwischen der Unterseite 5a des Jet-Coolers und der Oberseite der Grundplatte 11 erzeugt.

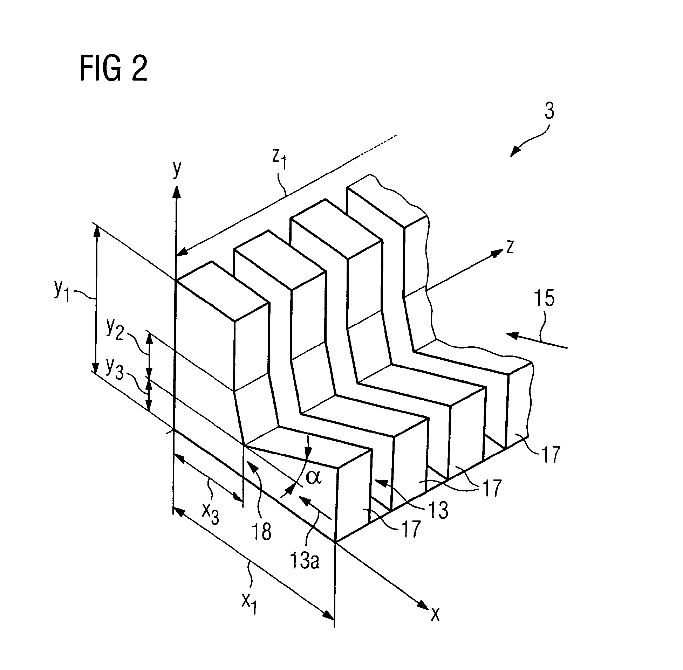

Gemäß FIG 2 ist in einer vereinfachten dreidimensionalen Darstellung der Kühlkörper 3 abgebildet. In X-Ausrichtung weist der Kühlkörper 3 eine Ausdehnung von X1 auf, in Y-Richtung weist der Kühlkörper eine Y-Ausdehnung von Y1 auf und in Z-Richtung eine Z-Ausdehnung von Z1. Die auf der XZ-Ebene senkrecht stehenden Kühlrippen 17 bilden dabei den Hauptstromkanal 13. In Richtung der Z-Ausdehnung weist der Kühlkörper an den Stellen X1 eine Y-Ausdehnung von Y2 auf. Zur Bildung einer Schräglage für die spätere Aufnahme des aus FIG 1 bekannten Jet-Coolers 5 weisen die Y-Werte einen Wert von Y3 an den Stellen X3 auf. Der Wert für Y3 ist kleiner als der Wert für Y2, somit wird ein Winkel α für die Schräglage von beispielsweise von 20°C gebildet. Durch diese Ausgestaltung wird an den Werten für X3 die Engstelle 18 in jeweils jedem, durch die Kühlrippen 17, der Unterseite des Jet-Coolers 5 und der in der XY-Ebene liegenden Unterseite des Kühlkörpers 3 gebildeten Strömungskanal innerhalb des Kühlkörpers ausgeformt.

## Patentansprüche

1. Kühlvorrichtung (1) mit einem Kühlkörper (3) zur Kühlung eines Bauteils (7), wobei der Kühlkörper (3) von einem Medium umströmbar ist, mit einer zumindest abschnittsweisen Führung eines Hauptstromes (13a) und eines Nebenstromes (15) des Mediums, wobei der Hauptstrom (13a) von dem Nebenstrom (15) bis zu einer Engstelle (18) durch ein Trennmittel getrennt ist und sich nach der Engstelle (18) der Nebenstrom (15) mit dem Hauptstrom (13a) vermischt, **dadurch gekennzeichnet, dass**
das Trennmittel zumindest teilweise durch eine Unterseite (5a) eines Kühlmittelstrahlerzeugungsmittels ausgestaltet ist, welches mit der Unterseite (5a) in einer Schräglage (α) zu einer dem Bauteil (7) zugewandten Fläche (9) des Kühlkörpers (3) angeordnet ist,
die Unterseite (5a) und die Fläche (9) als Begrenzungen eines Hauptstromkanals (13) für den Hauptstrom (13a) angeordnet sind,
von einem Hauptlufteintritt (13b) ein für den Hauptstrom (13a) zur Verfügung stehender Querschnitt bis zur Engstelle (18) abnimmt.

2. Kühlvorrichtung (1) nach Anspruch 1, wobei mehrere Kühlrippen (17) senkrecht zur Fläche (9) angeordnet sind.

3. Kühlvorrichtung (1) nach einem der vorhergehenden Ansprüche, wobei die Kühlrippen (17) derart ausgestaltet sind, dass der Nebenluftstrom (15) aus einer kühlrippenfreien Zone angesaugt wird.

4. Kühlvorrichtung (1) nach einem der Ansprüche 1 bis 3, wobei die Schräglage (α) in einem Winkel im Bereich von 45 bis 5 Grad, vorzugsweise im Bereich von 30 bis 10 Grad, vorzugsweise im Bereich von 25 bis 15 Grad zur Fläche (9) angeordnet ist.

5. Kühlvorrichtung (1) nach einem der Ansprüche 3 oder 4, wobei der Kühlkörper (3) Kühlrippen (17) aufweist, welche derart ausgestaltet sind, dass innerhalb eines durch die maximalen dreidimensionalen Abmessungen (X1, Y2, Z3) des Kühlkörpers (3) aufgespannten Raumes eine Ausnehmung zur Aufnahme des Kühlmittelstrahlerzeugungsmittels gebildet ist, wobei die Kühlrippen (17) senkrecht zur Unterseite (5a) angeordnet sind.

6. Kühlvorrichtung nach einem der Ansprüche 3 bis 5, wobei das Kühlmittelstrahlerzeugungsmittel derart auf den Kühlrippen (17) angeordnet ist, dass es über zumindest eine Öffnung (5c) das Medium zwischen die Kühlrippen (17) appliziert.

7. Kühlvorrichtung (1) nach einem der Ansprüche 1 bis 6, wobei an der Fläche (9) eine Grundplatte (11) angeordnet ist.

8. Elektronische Baugruppe (20) mit einem Gehäuse (21) und einer Kühlvorrichtung (3) nach Anspruch 1.

## Claims

1. Cooling facility (1) with a heat sink (3) for cooling a component (7), with a medium able to flow around the heat sink (3), with a guidance of a main flow (13a) and of secondary flow (15) of the mediums at least in sections, wherein the main flow (13a) is separated from the secondary flow (15) up to a constriction point (18) by a separation means and the secondary flow (15) is merged with the main flow (13a) after the constriction point (18),
**characterised in that**
the separation means are embodied at least partly by an underside (5a) of a coolant flow generation means, which is arranged with the underside (5a) in an angled position (α) to a surface (9) of the heat sink (3) facing towards the component (7),
the underside (5a) and the surface (9) are arranged as delimiters of a main flow channel (13) for the main flow (13a),
a cross section available for the main flow (13a) reduces from a main air entry point (13b) down to a constriction point (18).

2. Cooling facility (1) according to claim 1, wherein a number of cooling fins (17) are arranged perpendicular to the surface (9).

3. Cooling facility (1) according to one of the previous claims, wherein the cooling fins (17) are embodied such that the secondary air flow (15) is sucked in from an area free of cooling ribs.

4. Cooling facility (1) according to one of claims 1 to 3, wherein the angled position α is arranged at an angle in the range of 45 to 5 degrees, preferably in the range of 30 to 10 degrees, preferably in the range of 25 to 15 degrees to the surface (9).

5. Cooling facility (1) according to one of claims 3 or 4, wherein the heat sink (3) features cooling fins (17) which are embodied such that a recess for accepting the coolant flow generation means is formed within a space covered by the maximum three-dimensional measurements (X1, Y2, Z3) of the heat sink (3), wherein the cooling fins (17) are arranged perpendicular to the underside (5a).

6. Cooling facility according to one of claims 3 to 5, wherein the coolant flow generation means is arranged on the cooling fins (17) such that it applies the medium between the cooling fins (17) via at least one opening (5c).

7. Cooling facility (1) according to one of claims 1 to 6, wherein a base plate (11) is arranged on the surface (9).

8. Electronic module (20) with a housing (21) and a cooling facility (3) according to claim 1.

## Revendications

1. Dispositif (1) de refroidissement ayant un dissipateur (3) de chaleur pour refroidir un composant (7), un fluide pouvant passer sur le dissipateur (3) de chaleur, comprenant une conduite au moins par tronçon d'un courant (13a) principal et d'un courant (15) secondaire du fluide, le courant (13a) principal étant séparé du courant (15) secondaire jusqu'à un étranglement (18) par un moyen de séparation et le courant (15) secondaire se mélangeant après l'étranglement (18) au courant (13a) principal, **caractérisé en ce que**
le moyen de séparation est conformé au moins en partie par un côté (5a) inférieur d'un moyen de production d'un jet de fluide de refroidissement, qui est disposé par le côté (5a) inférieur en une position (α) inclinée par rapport à une surface (9) du dissipateur (3) de chaleur tournée vers le composant (7),
le côté (5a) inférieur et la surface (9) sont disposés en tant que démarcations d'un conduit (13) pour le courant principal (13a),
une section transversale disponible pour le courant (13a) principal diminuant de l'entrée (13b) d'air principal à l'étranglement (18).

2. Dispositif (1) de refroidissement suivant la revendication 1, dans lequel plusieurs ailettes (17) de refroidissement sont disposées perpendiculairement à la surface (9).

3. Dispositif (1) de refroidissement suivant l'une des revendications précédentes, dans lequel les ailettes (17) de refroidissement sont conformées de manière à aspirer le courant (15) d'air secondaire d'une zone sans ailette de refroidissement.

4. Dispositif (1) de refroidissement suivant l'une des revendications 1 à 3, dans lequel la position (α) inclinée fait un angle de l'ordre de 45 à 5 degrés, de préférence de l'ordre de 30 à 10 degrés, de préférence de l'ordre de 25 à 15 degrés avec la surface (9).

5. Dispositif (1) de refroidissement suivant l'une des revendications 3 ou 4, dans lequel le dissipateur (3) de chaleur a des ailettes (17) de refroidissement, qui sont conformées de manière à former, à l'intérieur d'un espace délimité par les dimensions (X1, Y2, Z3) maximum en trois dimensions du dissipateur (3) de chaleur, un évidement de réception du moyen de production d'un jet de fluide de refroidissement, les ailettes (17) de refroidissement étant disposées perpendiculairement au côté (5a) inférieur.

6. Dispositif (1) de refroidissement suivant l'une des revendications 3 à 5, dans lequel le moyen de production d'un jet de fluide de refroidissement est disposé sur les ailettes (17) de refroidissement de manière à appliquer par au moins une ouverture (5c) le fluide entre les ailettes (17) de refroidissement.

7. Dispositif (1) de refroidissement suivant l'une des revendications 1 à 6, dans lequel une plaque (11) de base est mise sur la surface (9).

8. Composant (20) électronique ayant un boîtier (21) et un dispositif (3) de refroidissement suivant la revendication 1.
